# EUROPÄISCHE PATENTSCHRIFT

(11) **EP 0 446 323 B1**
(45) Veröffentlichungstag und Bekanntmachung des Hinweises auf die Patenterteilung: **13.07.1994**
(21) Anmeldenummer: 90914067.5
(22) Anmeldetag: 28.09.1990
(51) Int. Cl.: H05K 5/00

(54) **GEHÄUSE FÜR EINE ELEKTRONISCHE SCHALTUNG**
HOUSING FOR AN ELECTRONIC CIRCUIT
BOITIER POUR CIRCUITS ELECTRONIQUES

(30) Priorität: 04.10.1989 DE 3933123
(43) Veröffentlichungstag der Anmeldung: 18.09.1991
(73) Patentinhaber: ROBERT BOSCH GMBH, 70442 Stuttgart (DE)
(72) Erfinder: SCHUPP, Karl, D-7530 Pforzheim (DE); KARR, Dieter, D-7533 Tiefenbronn (DE)
(86) Internationale Anmeldenummer: DE9000741
(87) Internationale Veröffentlichungsnummer: WO9105451

(56) Entgegenhaltungen:
- EP-A- 0 335 783
- FR-A- 2 328 353
- FR-A- 2 634 617
- GB-A- 2 197 755

## Beschreibung

### Stand der Technik

Die Erfindung betrifft ein Gehäuse für eine elektronische , mit Anschlußstecker versehene Schaltung, insbesondere für eine Steuergeräteelektronik einer Brennkraftmaschine eines Fahrzeugs, mit einem Rahmen, an dem eine die elektronische Schaltung aufweisende Leiterplatte befestigt ist, und mit einem Kühlkörper, dem Leistungs-Bauelemente der elektronischen Schaltung zugeordnet sind, sowie mit einer die Leiterplatte umfangenden Abdeckung. Ein derartiges Gehäuse ist aus EP-A-0 335 783 bekannt.

Gehäuse für elektronische Schaltungen, die Umwelteinflüssen ausgesetzt sind, müssen dicht schliessen. Bekannt sind aufwendige Konstruktionen mit Dichtungseinlagen. Aus der DE-PS 25 46 334 geht ein elektronisches Steuergerät mit einem Gehäuse hervor, das einen Kühlrahmen aufweist. Der Kühlrahmen besitzt einen Boden, auf dem sich erwärmende Bauelemente einer Leistungsstufe befinden. Der Kühlrahmen erfordert ein relativ kompliziert ausgebildetes Metallprofil. Die bekannte Version ist daher recht kostenintensiv. Da der Kühlrahmen von einer haubenartigen Abdeckung überfangen wird, ist bei der Auslegung darauf zu achten, daß die von der Leistungsstufe erzeugte Verlustwärme in einem derartigen Maße abgeführt wird, daß keine unzulässige Erwärmung stattfindet.

### Vorteile der Erfindung

Der Erfindungsgegenstand mit den im Hauptanspruch genannten Merkmalen hat demgegenüber den Vorteil, daß bei sehr einfacher, kostengünstiger Ausbildung ein dicht schließendes Gehäuse vorliegt, daß ausgezeichnete Wärmeableiteigenschaften für wärmeerzeugende Bauelemente aufweist. Es besitzt einen gespritzten Kunststoffrahmen, in den mindestens ein Wärmeleitsteg wenigstens eines Kühlkörpers eingeformt ist. Bei der Herstellung wird der Wärmeleitsteg im Kunststoffspritzverfahren eingebettet, so daß eine spaltfreie und dichte Ausbildung gewährleistet ist. Das eine Ende des Wärmeleitstegs geht in eine im Gehäuseinneren liegende Bauelement-Montagefläche über und das andere Ende des Wärmeleitstegs ist als außerhalb des Gehäuses liegendes Wärmeabführelement ausgebildet. Die von auf der Bauelement-Montagefläche angeordneten Bauelementen erzeugte Wärme wird daher direkt über den eingebetteten Wärmeleitsteg aus dem Gehäuseinneren herausgeführt, so daß ausgezeichnete Kühleigenschaften vorliegen. Außerhalb des Gehäuses erfolgt eine Wärmeableitung durch das Wärmeabführelement, wobei vorzugsweise eine Einstückigkeit zwischen Bauelement-Montagefläche, Wärmeleitsteg und Wärmeabführelement vorliegt, so daß extrem kleine Wärmeübergangswiderstände vorliegen. Trotz eines dicht schließenden Gehäuses ist auf die genannte Art und Weise eine besonders effektive Wärmeabfuhr gewährleistet. Der Kunststoffrahmen stellt dabei eine besonders einfache und kostengünstige Lösung dar. Der Kühlkörper besteht vorzugsweise aus Metall.

Eine Doppelfunktion wird vom Wärmeabführelement übernommen, wenn dieses gleichzeitig als Gehäuse-Befestigungsanschluß ausgebildet ist. Überdies werden hierdurch die Wärmeableiteigenschaften noch weiter verbessert, da über die Befestigung die vom Wärmeleitsteg transportierte Wärme aufgenommen bzw. weitergeleitet wird, so daß Wärmestaus vermieden sind.

Insbesondere ist der Gehäuse-Befestigungsanschluß ein mit einer Bohrung für ein Befestigungselement versehener Flansch. Die dem Flansch zugeführte Wärme kann daher über das Befestigungselement an eine Tragkonstruktion oder dergleichen weitergegeben werden. Sofern das Gehäuse eine Steuergeräteelektronik für eine Brennkraftmaschine aufnimmt, wird die von entsprechenden Leistungshalbleitern erzeugte Wärme über z.B. als Gewindeschrauben ausgebildete Befestigungselemente zum Chassis oder zur Karosserie des Kraftfahrzeugs abgeleitet. Dieses führt zu ausgezeichneten Kühlungseigenschaften. Da die elektronische Schaltung an Versorgungs- und Datenleitungen angeschlossen werden muß, ist ein Anschlußstecker vorgesehen. Dieser läßt sich auf besonders einfache Weise dadurch am Gehäuse festlegen, wenn er in den Kunststoffrahmen eingeformt ist. Mithin wird bei der Rahmenherstellung nicht nur der Wärmeleitsteg des Kühlkörpers, sondern auch der Anschlußstecker mit Kunststoff umspritzt. Damit ist auch beim Anschlußstecker ein spaltfreier Übergang zum Kunststoffrahmen garantiert.

Nach einer bevorzugten Ausführungsform der Erfindung weist der Kunststoffrahmen angespritzte Schnappvorsprünge auf, die in Bohrungen der Leiterplatte einrastbar sind. Die Festlegung der Leiterplatte kann somit am Kunststoffrahmen durch eine einfache Rastverbindung erfolgen. Die Leiterplatte wird bei der Montage den einstückig mit dem Kunststoffrahmen ausgebildeten Schnappvorsprüngen derart zugeordnet, daß letztere mit den Bohrungen fluchten. Anschließend erfolgt die Verrastung. Es ist auch denkbar, daß entsprechend ausgebildete Schnappvorsprünge hinter die umlaufende Randkante der Leiterplatte greifen.

Zusätzlich oder alternativ kann die Leiterplatte auch durch in den Kunststoffrahmen eingeformte Metallstifte gehalten werden, die in Bohrungen der Leiterplatte eingreifen. Die Metallstifte sind vorzugsweise derart abgebogen, daß ein Herausrutschen aus den Bohrungen verhindert ist. Eine besonders haltbare Verbindung ergibt sich dann, wenn die Metallstifte die Leiterplatte vorzugsweise bis zum Leiterplattenlötvorgang aufgrund ihrer Abbiegungen halten und daß anschließend durch den Lötvorgang eine halternde Lötverbindung zwischen den Stiften und der Leiterplatte hergestellt wird. Hierzu weisen die Bohrungen der Leiterplatte vorzugsweise metallische oder metallisierte Bereiche, insbesondere Leiterbahnen auf, so daß eine hochbelastbare Lötverbindung ausgebildet werden kann.

Die Abdeckung ist vorzugsweise von zwei GehäuseKunststoffschalen gebildet, die mit der Ober- und Unterseite des Kunststoffrahmens verbunden, vorzugsweise verschweißt, sind. Durch die Verschweissung ist auf besonders einfache Weise ein dicht schließendes Gehäuse realisiert. In einem Arbeitsgang kann z.B. im Plisterverfahren eine Verschweissung erfolgen, wobei die beiden Gehäuse-Kunststoffschalen durch Schließen entsprechender Werkzeuge und Beheizen der Werkzeugstempel mit dem Kunststoffrahmen verbunden werden.

Um eine hohe elektromagnetische Verträglichkeit (EMV) zu erzielen, so daß weder von der elektronischen Schaltung eine Störabstrahlung nach außen, noch eine Störeinstrahlung nach innen erfolgen kann, sind die Gehäuse-Kunststoffschalen vorzugsweise metallisiert.

### Zeichnung

Die Erfindung wird im folgenden anhand der Figuren näher erläutert. Es zeigen:
Figur 1 eine perspektivische Ansicht eines aus Kunststoff bestehenden Gehäuserahmens, an dem eine Leiterplatte befestigt ist und der einen eingeformten Kühlkörper sowie einen eingeformten Anschlußstecker aufweist,
Figur 2 eine Seitenansicht eines erfindungsgemäßen Gehäuses mit einer aus zwei Kunststoffschalen bestehenden Abdeckung,
Figur 3 eine Detail-Schnittansicht der Befestigungszone der Gehäuse-Kunststoffschalen am Kunststoffrahmen und
Figur 4 einen mit Schnappvorsprung ausgebildeten Kunststoffrahmenabschnitt zur Befestigung der Leiterplatte.

### Beschreibung von Ausführungsbeispielen

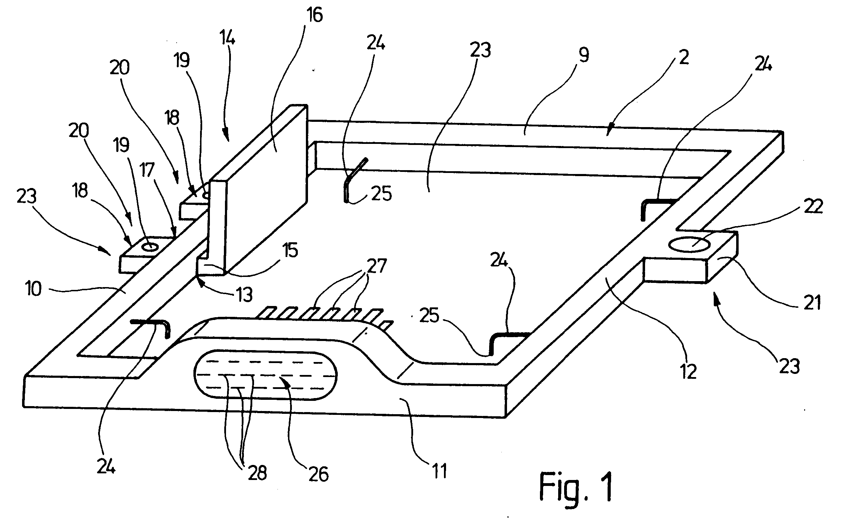

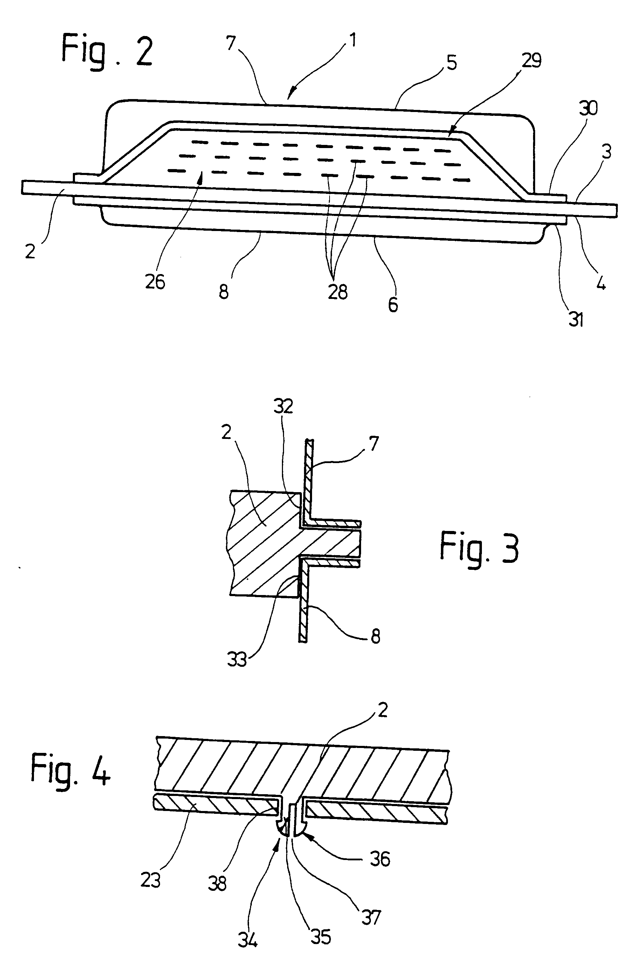

Das erfindungsgemäße Gehäuse 1 weist gemäß der Figuren 1 und 2 einen geschlossenen, in Spritztechnik hergestellten Kunststoffrahmen 2 auf. Auf der Oberseite 3 sowie der Unterseite 4 des Kunststoffrahmens 2 sind zwei Gehäuse-Kunststoffschalen 5 und 6 befestigt. Die Gehäuse-Kunststoffschale 5 bildet eine wannenförmige, relativ tiefe Oberschale 7 und die Gehäuse-Kunststoffschale 6 ist als ebenfalls wannenförmige, jedoch flachere Unterschale 8 ausgebildet.

Im nachfolgenden soll zunächst auf den Kunststoffrahmen 2 eingegangen werden. Dieser besitzt gemäß Figur 1 vier einstückig miteinander verbundene Rahmenschenkel 9, 10, 11 und 12. In den Rahmenschenkel 10 ist ein Wärmeleitsteg 13 eines Kühlkörpers 14 eingebettet. Der Wärmeleitsteg 13 wird also bei der Herstellung des Kunststoffrahmens 2 mit Kunststoff umspritzt. Im Rahmeninneren geht der Wärmeleitsteg 13 an seinem einen Ende 15 in eine abgewinkelte Bauelement-Montagefläche 16 über. Das andere Ende 17 des Wärmeleitstegs 13 ist einstückig mit einem außerhalb des Kunststoffrahmens 12 gelegenen Wärmeabführelement 18 verbunden. Der im Ausführungs- beispiel der Figur 1 gezeigte Kühlkörper 14 besitzt zwei jeweils zu der Bauelement-Montagefläche 16 führende Wärmeleitstege 13, die beide in den Rahmenschenkel 10 eingeformt sind und an ihren Enden 17 jeweils ein Wärmeabführelement 18 aufweisen. Die Wärmeabführelemente 18 besitzen jeweils eine Bohrung 19 für Befestigungselemente, so daß sie Befestigungsanschlüsse 20 für den Kunststoffrahmen 2 und damit für das Gehäuse 1 bilden. Mittels geeigneter Befestigungselemente, die in die Bohrungen 19 eingreifen, kann eine Festlegung an einem geeigneten Montageort erfolgen.

Für eine Befestigung können am Kunststoffrahmen 2 ferner angespritzte Laschen 21 ausgebildet sein, die mit Befestigungsbohrungen 22 versehen sind (siehe Rahmenschenkel 12 in Figur 1). Da die Befestigungsanschlüsse 20 und auch die Laschen 21 über die Rahmenperipherie herausspringen, werden von diesen Elementen Flansche 23′ gebildet, die eine besonders einfache Montage des Gehäuses 1 ermöglichen.

An den Rahmenschenkeln 9, 10, 11 und 12 ist eine Leiterplatte 23 befestigt, die eine elektronische Schaltung, vorzugsweise eine Steuergeräteelektronik, aufweist (nicht dargestellt). Die Leiterplatte 23 befindet sich entweder im Rahmeninneren oder sie wird derart an der Unterseite 4 des Kunststoffrahmens 2 angeordnet, daß keine Rahmenteile über die Unterseite der Leiterplatte 23 hinausragen. Zur Befestigung sind in den Kunststoffrahmen 2 eingeformte Metallstifte 24 vorgesehen, die in Bohrungen 25 der Leiterplatte 23 eingreifen und letztere durch an der Unterseite der Leiterplatte erfolgendes Abbiegen halten. Den Bohrungen 25 sind metallische/metallisierte Bereiche, insbesondere Leiterbahnen zugeordnet, so daß bis zu einem Lötvorgang die Leiterplatte durch die umgebogenen Metallstifte 24 gehalten ist und nach dem Löten eine feste Verbindung zwischen den Metallstiften 24 und der Leiterplatte 23 besteht.

Alternativ ist es jedoch auch möglich, daß die Leiterplatte 23 mittels Schrauben an dem Kunststoffrahmen 2 gehaltert ist.

Da die elektronische Schaltung der Leiterplatte 23 an Versorgungs- und Datenleitungen angeschlossen werden muß, ist ein Anschlußstecker 26 vorgesehen, der in den Rahmenschenkel 11 des Kunststoffrahmens 2 eingebettet ist. Er wird bei der Herstellung des Kunststoffrahmens 2 mit Kunststoff umspritzt, so daß eine spaltfreie Abdichtung gewährleistet ist. Die Kontaktfahnen 27 der Kontakte 28 des Anschlußsteckers 26 sind in geeigneter Weise mit der auf der Leiterplatte 23 angeordneten elektronischen Schaltung verbunden, Letztere weist wärmeerzeugende Leistungs-Bauelemente auf (nicht dargestellt), die auf der Bauelement-Montagefläche 16 des Kühlkörpers 14 mit möglichst geringem Wärmeübergangswiderstand angeordnet sind.

Gemäß Figur 2 ist es alternativ auch möglich, daß der Anschlußstecker 26 auf der Oberseite 3 des Kunststoffrahmens 2 angeordnet ist, wobei die Oberschale 7 des Gehäuses 1 eine formangepaßte Randkontur 29 aufweist, die dichtschließend an der Oberseite des Anschlußsteckers 26 anliegt.

Oberschale 7 und Unterschale 8 weisen abgewinkelte Randstege 30 bzw. 31 auf, die mit der Oberseite 3 bzw. der Unterseite 4 des Kunststoffrahmens 2 umlaufend verschweißt sind. Dieses wird bevorzugt in einem Arbeitsgang, und zwar im sogenannten Plisterverfahren, durchgeführt, wobei die beiden Gehäuse-Kunststoffschalen 5 und 6 durch Schließen eines geeigneten Werkzeugs mit beheiztem Werkzeug stempel mit dem Kunststoffrahmen 2 dicht verschweißt werden.

Zur Erzielung einer hohen elektromagnetischen Verträglichkeit sind die Gehäuse-Kunststoffschalen 5 und 6 mit einer Metallisierung versehen. Hierzu werden sie entweder mit Metall bedampft oder mit einer Metalleinlage ausgestattet. Sie können im Spritzverfahren oder im Tiefziehverfahren hergestellt sein.

Bei der Montage wird zunächst die Unterschale 8 in ein Werkzeug eingelegt, dann wird der Kunststoffrahmen 2 mit der an ihm befestigten Leiterplatte 23 in durch geeignete Fügehilfen ausgerichteter Position an die Unterschale 8 angelegt und schließlich das Gehäuse durch Aufbringen der Oberschale 7 komplettiert.

Bei der Herstellung der Rahmen/Leiterplatteneinheit werden vorzugsweise sogenannte Leiterplattennutzen verwendet, auf denen mehrere Kunststoffrahmen 2 Platz finden, so daß gleichzeitig mehrere Leiterplatten mittels der zuvor beschriebenen Metallstifte 24 gleichzeitig über ein Lötbad gefahren werden können. Nach dem Verlöten werden aus den Leiterplattennutzen die einzelnen Leiterplatten 23 mit den daran befestigten Kunststoffrahmen 2 herausgebrochen oder herausgestanzt. Die Herstellung wird dadurch besonders wirtschaftlich.

Die Figur 3 zeigt, daß der Kunststoffrahmen 2 im Befestigungsbereich mit den Gehäuse-Kunststoffschalen 5 und 6 stufenförmig ausgebildet sein kann. In die eine Stufe 32 greift die Oberschale 7 und in die andere Stufe 33 die Unterschale 8 ein. Der Verbindungsbereich zwischen den Schalen und dem Rahmen wird dadurch besonders großflächig ausgebildet, so daß bei der Schweißung eine absolut dichte Verbindung entsteht. Es kann auch anstatt der Schweißung eine Verklebung erfolgen.

Alternativ zu den bereits beschriebenen Leiterplattenfestlegungen ist es gemäß Figur 4 auch möglich, daß der Kunststoffrahmen 2 einstückig angespritzte Schnappvorsprünge 34 aufweist. Jeder Schnappvorsprung 34 weist einen Steg 35 auf, der einen kopfförmigen Endbereich 36 besitzt. Kopfbereich 36 und Steg 35 sind mit einem Schlitz 37 versehen. Die Leiterplatte 23 weist dem Durchmesser des Stegs 35 angepaßte Bohrungen 38 auf. Für die Befestigung der Leiterplatte 23 wird diese mit ihren Bohrungen 38 auf die Schnappvorsprünge 34 gedrückt, wobei aufgrund des Schlitzes 37 der kopfförmige Endbereich 36 seinen Durchmesser verkleinert, so daß der Steg 35 in die Bohrung 38 eingreifen kann. Im aufgesteckten Zustand federt der Endbereich 36 wieder auseinander, so daß ein Hintergriff zur Leiterplatte 23 entsteht.

## Patentansprüche

1. Gehäuse (1) für eine elektronische, mit Anschlußstecker (26) versehene Schaltung, insbesondere für eine Steuerelektronik einer Brennkraftmaschine eines Fahrzeugs, mit einem Rahmen (2), an dem eine die elektronische Schaltung aufweisende Leiterplatte (23) befestigt ist, und mit einem Kühlkörper (14), dem Leistungs-Bauelemente der elektronischen Schaltung zugeordnet sind, sowie mit einer die Leiterplatte umfangenden Abdeckung (5, 6), **dadurch gekennzeichnet,** daß der Rahmen als gespritzter Kunststoffrahmen (2) mit mindestens einem eingeformten Wärmeleitsleg (13) des Kühlkörpers (14) ausgebildet ist, wobei das eine Ende (15) des Wärmeleitstegs (13) in eine im Gehäuseinneren liegende Bauelemente-Montagefläche (16) übergeht und das andere Ende (17) des Wärmeleitstegs (13) als außerhalb des Gehäuse (1) liegendes Wärmeabführelement (18) ausgebildet ist.

2. Gehäuse nach Anspruch 1, **dadurch gekennzeichnet,** daß das Wärmeabführelement (18) als Gehäuse-Befestigungsanschluß (20) ausgebildet ist.

3. Gehäuse nach Anspruch 2, **dadurch gekennzeichnet,** daß der Gehäuse-Befestigungsanschluß (20) ein mit einer Bohrung (19) für ein Befestigungselement versehener Flansch (23′) ist.

4. Gehäuse nach einem der vorhergehenden Ansprüche, **dadurch gekennzeichnet,** daß in den Kunststoffrahmen (2) der Anschlußstecker (26) eingeformt ist.

5. Gehäuse nach einem der vorhergehenden Ansprüche, **dadurch gekennzeichnet,** daß der Kunststoffrahmen (2) angespritzte Schnappvorsprünge (34) aufweist, die in Bohrungen (38) der Leiterplatte (23) einrastbar sind.

6. Gehäuse nach einem der vorhergehenden Ansprüche, **gekennzeichnet durch** in den Kunststoffrahmen (2) eingeformte Metallstifte (24), die in Bohrungen (25) der Leiterplatte (23) eingreifen und diese durch Abbiegung halten.

7. Gehäuse nach Anspruch 6, **dadurch gekennzeichnet,** daß die Metallstifte (24) die Leiterplatte (23) vorzugsweise bis zum Leiterplattenlötvorgang durch Abbiegung halten und daß den Bohrungen (25) der Leiterplatte (23) metallische/metallisierte Bereiche, insbesondere Leiterbahnen, derart zugeordnet sind, daß nach dem Lötvorgang eine halternde Lötverbindung zwischen den Metallstiften (24) und der Leiterplatte (23) besteht.

8. Gehäuse nach einem der vorhergehenden Ansprüche, **dadurch gekennzeichnet,** daß die Abdeckung von zwei Gehäuse-Kunststoffschalen 6) gebildet ist, die mit der Ober- und Unterseite (3, 4) des Kunststoffrahmens (2) verbunden, insbesondere verschweißt, sind.

9. Gehäuse nach Anspruch 8, **dadurch gekennzeichnet,** daß die Gehäuse-Kunststoff, schalen (5, 6) metallisiert sind.

## Claims

1. Housing (1) for an electronic circuit provided with a connector plug (26), in particular for control electronics of an internal combustion engine of a vehicle, having a frame (2) to which a printed circuit board (23) which has the electronic circuit is attached, and having a cooling element (14) to which power components of the electronic circuit are assigned, and having a cover (5, 6) which surrounds the printed circuit board, characterized in that the frame is constructed as an injection-moulded plastic frame (2) with at least one formed-in heat conducting web (13) of the cooling element (14), one end (15) of the heat conducting web (13) merging with a component mounting face (16) which is located in the interior of the housing and the other end (17) of the heat conducting web (13) being constructed as an element (18) for conducting away heat which is located outside the housing (1).

2. Housing according to Claim 1, characterized in that the element (18) for conducting away heat is constructed as a housing-attachment connection (20).

3. Housing according to Claim 2, characterized in that the housing-attachment connection (20) is a flange (23′) provided with a bore (19) for an attachment element.

4. Housing according to one of the preceding claims, characterized in that the connector plug (26) is formed into the plastic frame (2).

5. Housing according to one of the preceding claims, characterized in that the plastic frame (2) has snap-in projections (34) which are injection-moulded on and can be engaged in bores (38) of the printed circuit board (23).

6. Housing according to one of the preceding claims, characterized by metal pins (24) which are formed into the plastic frame (2) and engage in bores (25) of the printed circuit board (23) and hold them by bending.

7. Housing according to Claim 6, characterized in that the metal pins (24) hold the printed circuit board (23) by bending preferably until the soldering process for the printed circuit board, and in that the bores (25) of the printed circuit board (23) are assigned metallic/metallized regions, in particular conductor tracks, in such a way that after the soldering process a securing solder connection exists between the metal pins (24) and the printed circuit board (23).

8. Housing according to one of the preceding claims, characterized in that the cover is formed by two plastic housing shells (5, 6) which are connected, in particular fused, to the upper side and underside (3, 4) of the plastic frame (2).

9. Housing according to Claim 8, characterized in that the plastic housing shells (5, 6) are metallized.

## Revendications

1. Boîtier (1) destiné à recevoir un circuit électronique (25) équipé d'un connecteur à broches, notamment une électronique de commande d'un moteur à combustion interne de véhicule, comportant un cadre (2), sur lequel est fixé un circuit imprimé (23) portant le circuit électronique, un refroidisseur (14) associé aux éléments de puissance du circuit, ainsi qu'une enveloppe (5, 6) recouvrant le circuit imprimé, caractérisé en ce que le cadre est un cadre en plastique (2) réalisé par injection, incorporant au moulage au moins une lame thermoconductrice (13) du refroidisseur (14), l'une des extrémités de la lame jouant le rôle, à l'intérieur du cadre, de portée de montage (16) de composants tandis que l'autre extrémité (17) constitue, à l'extérieur du cadre, l'élément (18) d'évacuation de la chaleur.

2. Boîtier selon la revendication 1, caractérisé en ce que l'élément (18) d'évacuation de la chaleur constitue un raccord de fixation (20) du boîtier.

3. Boîtier selon la revendication 2, caractérisé en ce que le raccord de fixation (20) du boîtier est constitué par une bride (23′) percée d'un trou (19) destiné à un élément de fixation.

4. Boîtier selon une des revendications précédentes, caractérisé en ce que le connecteur à broches (26) est incorporé, au moulage, dans le cadre en plastique (2).

5. Boîtier selon une des revendications précédentes, caractérisé en ce que le cadre en plastique (2) comporte des tétons d'encliquetage (34) moulés, qui peuvent être bloqués dans des trous (38) du circuit imprimé (23).

6. Boîtier selon une des revendications précédentes, caractérisé en ce que des broches métalliques (24), incorporées lors du moulage dans le cadre en plastique (2), sont engagées dans des trous (25) du circuit imprimé et, par rabattement, maintiennent celui-ci.

7. Boîtier selon la revendication 6, caractérisé en ce que les broches métalliques (24) maintiennent, par leur rabattement, le circuit imprimé jusqu'au moment de la soudure du circuit imprimé, tandis que des zones métalliques ou métallisées, en particulier des pistes conductrices, sont associées aux trous (25) du circuit (23) de maniére qu'après l'opération de soudure, il existe une liaison durable par soudure entre les broches métalliques (24) et le circuit imprimé (23).

8. Boîtier selon une des revendications précédentes, caractérisé en ce que l'enveloppe est constituée de deux coques (5 6) de boîtier, en matière plastique, reliées aux faces supérieure et inférieure (3, 4) du cadre, notamment par soudure.

9. Boîtier selon la revendication 8, caractérisé en ce que les coques (5, 6) sont métallisées.
